# EUROPÄISCHE PATENTANMELDUNG

(11) **EP 1 937 042 A2**
(43) Veröffentlichungstag der Anmeldung: **25.06.2008**
(21) Anmeldenummer: 07122584.1
(22) Anmeldetag: 07.12.2007
(51) Int. Cl.: H05K 1/14, H05K 1/18

(54) **Anschlusssystem für ein Display-Modul**

(30) Priorität: 21.12.2006 DE 102006060756
(71) Anmelder: Siemens Home and Office Communication Devices GmbH & Co. KG, 81379 München (DE)
(72) Erfinder: Brooren, Andreas, 46395 Bocholt (DE); Plugge, Thomas, 85640 Putzbrunn (DE)
(74) Vertreter: Maier, Daniel Oliver

(57) **Zusammenfassung**

Es wird ein Anschlusssystem (5, 6) für ein Display-Modul (1) vorgeschlagen, das preiswert ist und gleichzeitig die Möglichkeit bietet, dass das Display-Modul (1) eine Beleuchtung hat. Ein solches Anschlusssystem (5, 6) weist eine erste und eine zweite flexible Leiterbahnenfolie (5, 6) auf, die miteinander zu einer einzigen gesamten Leiterbahnenverbindung verbunden sind und eine elektrische Verbindung zwischen dem Display-Modul (1) und einer zugeordneten Leiterplatte, auf der eine Steuerschaltung zur Steuerung des Display-Moduls (1) angeordnet ist, herstellt. Die erste flexible Leiterbahnenfolie (5) weist gegenüber der zweiten flexiblen Leiterbahnenfolie (6) Leiterbahnen auf, die geringere Leiterbahnenwiderstände haben. Außerdem ist sie so gefertigt, dass auf ihr elektrische Bauelemente montierbar sind. Die zweite flexible Leiterbahnenfolie (6) weist preisgünstigere Leiterbahnen und damit Leiterbahnen mit höheren Leiterbahnenwiderständen auf. Die erste flexible Leiterbahnenfolie (5) ist bezüglich der mechanischen Abmessungen im Wesentlichen beschränkt auf das Display-Modul (1) ausgeführt. Die zweite flexible Leiterbahnenfolie (6) ist bezüglich der mechanischen Abmessungen in der Weise ausgeführt, dass durch die zweite flexible Leiterbahnenfolie (6) im Wesentlichen die gesamte Strecke zwischen dem Display-Modul (1) und der entsprechenden Leiterplatte überbrückt ist.

## Beschreibung

Die Erfindung betrifft ein Anschlusssystem für ein Display-Modul gemäß dem Oberbegriff des Anspruchs 1.

Es ist bekannt, für den Anschluss eines Display-Moduls an eine Leiterplatte, die Teil einer Steuerschaltung ist, über die das Display-Modul gesteuert ist, eine flexible Leiterbahnenverbindung zu verwenden. Die flexible Leiterbahnenverbindung ist zum Display-Modul über einen Kontrollbaustein, der auf dem Display-Modul angeordnet und durch den das Display-Modul gesteuert ist, mit dem Display-Modul und zur Leiterplatte mit der Leiterplatte kontaktiert. Zwischen diesen jeweiligen Kontaktierungen wird die elektrische Verbindung zwischen jeweils einander zugehöriger Kontaktpunkte auf Seiten des Display-Moduls und auf Seiten der Leiterplatte durch jeweilige Leiterbahnen der flexiblen Leiterbahnenverbindung bewerkstelligt. Mit anderen Worten, die flexible Leiterbahnenverbindung überbrückt in elektrischer Hinsicht die Strecke zwischen dem Display-Modul und der betreffenden Leiterplatte.

Die flexible Leiterbahnenverbindung kann beispielsweise eine so genannte FPC-Folie sein. Sie kann aber auch beispielsweise eine so genannte Heatseal-Folie sein.

Der Aufbau und der Verarbeitungsprozess sind bei der FPC-Folie aufwändiger und teurer als bei der Heatseal-Folie. Die FPC-Folie ist daher teurer als die Heatseal-Folie.

Die FPC-Folie hat aber den Vorteil, dass auf ihr elektrische Bauteile anbringbar sind, was bei der Heatseal-Folie nicht möglich ist. Wenn also bei einem Display-Modul auch eine Beleuchtung, zum Beispiel so genannte LED's, also Licht erzeugende und Licht abgebende elektrische Bauteile, die einen relativ hohen Stormbedarf haben, angeschlossen werden sollen, ist die teurere FPC-Folie verwendbar, während die billigere Heatseal-Folie nicht verwendbar ist.

Außerdem weist die FPC-Folie als Leiterbahnen Kupferleiterbahnen auf, die einen sehr niedrigen Leitungswiderstand haben. Sie verursachen deshalb keinen signifikanten Leitungsverlust, wenn höhere Ströme fließen müssen, wie das der Fall ist, wenn beispielsweise Licht erzeugende und Licht abgebende elektrische Bauteile mit elektrischer Energie versorgt werden müssen.

Heatseal-Folien weisen Karbonleiterbahnen auf, die einen relativ hohen Leitungswiderstand haben. Müssen über diese Leiterbahnen höhere Ströme fließen, ist das mit signifikanten Leitungsverlusten verbunden.

Für die Übertragung von spannungsgesteuerten elektrischen Signalen sind sie jedoch geeignet, weil die damit zusammenhängenden kleinen Signalströme keine ins Gewicht fallenden Leitungsverluste auf den Karbonleitungen verursachen. Soweit die erhöhten Leiterbahnenwiderstände der Heatseal-Folie die Signalströme doch beeinflussen, kann diese Beeinflussung durch eine entsprechende geringfügige Verstärkung dieser Signalströme kompensiert werden. Die Verstärkung kann dabei soweit in Grenzen gehalten werden, dass damit keine signifikante Erhöhung eines Leitungsverlustes verbunden ist. Weiter ziehen auch die Maßnahmen, die für die Verstärkung der Signalströme vorzunehmen sind, keine relevante Kostenerhöhung nach sich, weil die für die Bereitstellung der Signalströme verwendeten Schaltungsbauteile ohnehin vorhanden sind und diese ohne Weiteres in der Lage sind, auch die geringfügig erhöhten Signalströme zu liefern. Die besagten Schaltungsbauteile sind lediglich in einer modifizierten Art und Weise elektrisch anzusteuern.

In diesem Zusammenhang ist darauf verwiesen, dass der Kontrollbaustein auf dem Display-Modul ein elektrischer Baustein ist, der die Ansteuersignale spannungsgesteuert erhält. Eine Ansteuerung über höhere Leitungswiderstände aufweisende Leitungen ist daher nicht von entscheidender Bedeutung. Soweit die damit zusammenhängenden kleinen Signalströme durch solche Umstände verändert sind, ist der Baustein in der Lage, durch seine eigenen Verstärkungssysteme diese Veränderungen zu kompensieren. Gegebenenfalls ist der Baustein mit etwas modifizierten Ansteuerungsbausteinen zu versehen, durch die er dann in die Lage versetzt ist, die entsprechenden Kompensationen durchzuführen.

Für die Übertragung von Versorgungsenergien beispielsweise solchen für Licht erzeugende und Licht abgebende elektrische Bauteile, die gegenüber Signalströmen signifikant höhere Ströme benötigen, ist eine Heatseal-Folie nicht ohne Weiteres geeignet. Hier werden durch die signifikant höheren Ströme im Zusammenhang mit den höheren Leitungswiderständen auch signifikant höhere Leitungsverluste generiert.

Aus dem Dokument US 2006/0103788 A1 ist für ein Display-Modul ein Anschlusssystem bekannt, welches eine flexible Leiterbahnenfolie verwendet für eine Verbindung zwischen Eingangs- und Ausgangsanschlüssen und auf welchem ein Halbleiterbaustein für die Steuerung des Display-Moduls angeordnet ist. Der Halbleiterbaustein erhält dabei über die flexible Leiterbahnenfolie die für die Steuerung des Display-Moduls notwendigen Signale.

Aus dem Dokument WO 2006/049358 A1 ist bekannt, um Ressourcen schonender einzusetzen, Leiterplatten aus Teilbereichen mit unterschiedlichen leitungsführenden Oberflächen zusammenzusetzen.

Aus dem Dokument US 2006/0256579 A1 ist bekannt, Display-Module stirnseitig mit Beleuchtungseinrichtungen zu versehen, die auf einer flexiblen Leiterbahnenfolie untergebracht ist. Die flexible Leiterbahnenfolie mit der darauf angeordneten Beleuchtungseinrichtung ist dabei zwar in die unmittelbare Nähe des Display-Moduls gebracht, steht aber ansonsten in keiner weiteren Wirkbeziehung mit dem Display-Modul.

Aufgabe der vorliegenden Erfindung ist es, ausgehend von einem Anschlusssystem für ein Display-Modul der eingangs genannten Art, ein solches Anschlusssystem in der Weise zu verbessern, dass es kostengünstig ist und es darüber hinaus für das Display-Modul möglich ist, dieses mit einer Beleuchtung zu versehen.

Diese Aufgabe wird erfindungsgemäß durch ein Anschlusssystem gelöst, das die im kennzeichnenden Teil des Anspruchs 1 angegebenen Merkmale aufweist.

Danach umfasst zum Anschluss eines Display-Moduls an eine Leiterplatte das betreffende Anschlusssystem als eine flexible Leiterbahnenverbindung neben einer ersten flexiblen Leiterbahnenfolie, welche zur Verbindung mit einem auf dem Display-Modul angeordneten Kontrollbaustein dient und die als sich im Wesentlichen über die Breite des Display-Moduls erstreckend ausgeführt ist, eine zweite flexible Leiterbahnenfolie auf, welche zur Verbindung der ersten flexiblen Leiterbahnenfolie mit der Leiterplatte vorgesehen ist. Dabei sind die erste und die zweite Leiterbahnenfolie miteinander kontaktiert. Auf der ersten flexiblen Leiterbahnenfolie sind Licht erzeugende elektrische Bauteile angeordnet, deren abgegebenes Licht in eine Stirnseite des Display-Moduls eingestrahlt wird, und zwar so, dass das Display-Modul durch das eingestrahlte Licht für einen Betrachter einer mit Hilfe des Display-Moduls erzeugten Anzeige mit einem Beleuchtungseffekt beaufschlagt ist. Außerdem weisen die Leiterbahnen der ersten flexiblen Leiterbahnenfolie gegenüber denen der zweiten flexiblen Leiterbahnenfolie geringere Leiterbahnenwiderstände auf.

Vorteilhaft bei einem solchen Anschlusssystem ist, dass es kostengünstig ist. Kostengünstig ist es, weil flexible Leiterbahnenfolien mit höheren Leiterbahnenwiderständen kostengünstiger sind als flexible Leiterbahnenfolien mit geringeren Leiterbahnenwiderständen und nahezu das gesamte Anschlusssystem mit dieser kostengünstigen Leiterbahnenfolie konstruiert ist.

Ein anderer Vorteil ist, dass es mit dem vorgeschlagenen Anschlusssystem möglich ist, auch auf Seiten des Display-Moduls elektrische Bauteile anzuordnen. Insbesondere vorteilhaft ist, dass es sich bei diesen elektrischen Bauteilen um elektrische Bauteile handeln kann, die gegenüber reinen Signalströmen auch höhere Stromflüsse benötigen können. Es ist deshalb möglich, auf Seiten des Display-Moduls auch Licht erzeugende und Licht abgebende elektrische Bauteile anzuordnen. Es ist insbesondere möglich, diese Bauteile auf der ersten flexiblen Leiterbahnenfolie zum Beispiel für Beleuchtungszwecke anzuordnen. Dabei ist es besonders vorteilhaft, wenn die Licht erzeugenden und Licht abgebenden elektrischen Bauteile in der Weise auf der ersten flexiblen Leiterbahnenfolie angeordnet sind, dass deren abgegebenes Licht in eine solche beispielsweise Stirnseite des Display-Moduls einstrahlt, dass das Display-Modul durch das eingestrahlte Licht für einen Betrachter einer mit Hilfe des Display-Moduls erzeugten Anzeige mit einem Beleuchtungseffekt beaufschlagt ist.

Der Umstand, dass auf Seiten des Display-Moduls elektrische Bauteile vorgesehen werden können, hat weiter den Vorteil, dass das Display-Modul bei seiner eigenen Herstellung schon mit solchen elektrischen Bauteilen bestückt werden kann. Bei einer späteren Montage des so vorbereiteten Display-Moduls entfällt dann der Arbeitsaufwand für die Montage dieser elektrischen Bauteile. Die späteren Montagearbeiten für die Montage des Display-Moduls verbilligen sich wiederum dadurch. Diese ist vorteilhaft, wenn zum Beispiel das Display-Modul in einer kostengünstigen Produktionsregion produziert und das so produzierte Display-Modul in einer anderen, möglicherweise teureren Produktionsregion endmontiert wird.

Vorteilhafte Ausgestaltungen der Erfindung sind Gegenstand von Unteransprüchen.

Danach ist die erste flexible Leiterbahnenfolie konkret eine FPC-Folie, die zwar teuer ist, auf der aber elektrische Bauteile zu montieren sind, und ist die zweite flexible Leiterbahnenfolie konkret eine Heatseal-Folie, die sehr preiswert ist.

Soweit höhere Ströme auch über die flexible Leiterbahnenfolie mit den höheren Leiterbahnenwiderstände zu führen sind, kann diesem Umstand ohne dadurch die Kosten zu erhöhen dadurch Rechnung getragen werden, dass die Leiterbahnen mit größeren Querschnitten versehen werden oder mehrere Leiterbahnen parallel geschaltet werden. Bei der teureren flexiblen Leiterbahnenfolie existiert dieses Problem ohnehin nicht.

In einer anderen vorteilhaften Ausgestaltung der Erfindung sind für elektrische Bauteile auf der ersten flexiblen Leiterbahnenfolie, die einen höheren Strombedarf haben, entsprechende Leiterbahnen auf der zweiten flexiblen Leiterbahnenfolie als parallel geschaltete Mehrfach-Leitungsstränge ausgebildet. Wenn auch die einzelne Leiterbahn des Mehrfach-Leitungsstrangs auf der zweiten flexiblen Leiterbahnenfolie für sich einen erhöhten Leitungswiderstand hat, verringert sich dieser Leiterbahnenwiderstand für den Mehrfach-Leitungsstrang als Ganzes. Entsprechendes wird erreicht, wenn die Querschnitte betreffender Leiterbahnen vergrößert ausgebildet sind.

Sind die erste flexible Leiterbahnenfolie bezüglich der mechanischen Abmessungen im Wesentlichen beschränkt auf das Display-Modul und die zweite flexible Leiterbahnenfolie bezüglich der mechanischen Abmessungen in der Weise ausgeführt, dass durch die zweite flexible Leiterbahnenfolie im Wesentlichen die gesamte Strecke zwischen dem Display-Modul und der Leiterplatte überbrückt ist, trägt dies zur Kostengünstigkeit des erfindungsgemäßen Anschlusssystems bei, weil flexible Leiterbahnenfolien mit höheren Leiterbahnenwiderständen kostengünstiger sind als flexible Leiterbahnenfolien mit geringeren Leiterbahnenwiderständen und nahezu das gesamte Anschlusssystem mit dieser kostengünstigen Leiterbahnenfolie konstruiert ist.

In einer weiteren vorteilhaften Ausgestaltung der Erfindung sind Teilstücke der ersten flexiblen Leiterbahnenfolie, genauer, Teilstücke, die Leiterbahnen betreffen, über die die zum Beispiel Licht erzeugenden elektrischen Bauteile mit elektrischer Energie versorgt sind, also Teilstücke, die einen höheren Strom führen müssen, bezüglich der mechanischen Abmessungen wesentlich über das Display-Modul hinausragend verlängert ausgebildet, und sind entsprechend zu diesen Teilstücken gehörige Teilstücke der zweiten flexiblen Leiterbahnenfolie in den mechanischen Abmessungen entsprechend verkürzt ausgebildet. Damit ist es möglich, in Bezug auf zum Beispiel genau diese besonders kritischen Übertragungsstrecken ein gesondertes Verhältnis zwischen den Abmessungen der ersten und zweiten flexiblen Leiterbahnenfolie einzustellen. Das hat den Vorteil, dass auf diese Weise Leitungsverluste reduziert werden können. Je größer der Anteil an Leiterbahnen mit geringem Leiterbahnenwiderstand ist, je geringer ist die Notwendigkeit, mit anderen Maßnahmen die durch Leiterbahnen mit höherem Leiterbahnenwiderstand hervorgerufenen Effekte zu kompensieren. Allerdings ist es gemäß der Erfindung so, dass, soweit diese Maßnahme angewendet wird, diese Maßnahme nur auf diese besonderen Leiterbahnen angewendet wird.

Nachfolgend wird ein Ausführungsbeispiel der Erfindung anhand einer Zeichnung näher erläutert. Darin zeigen
- Figur 1: ein Display-Modul in Draufsicht mit einer Heatseal-Folie als flexible Leiterbahnenverbindung gemäß dem Stand der Technik, und
- Figur 2: ein Display-Modul in Unteransicht mit einem Anschlusssystem gemäß der Erfindung.

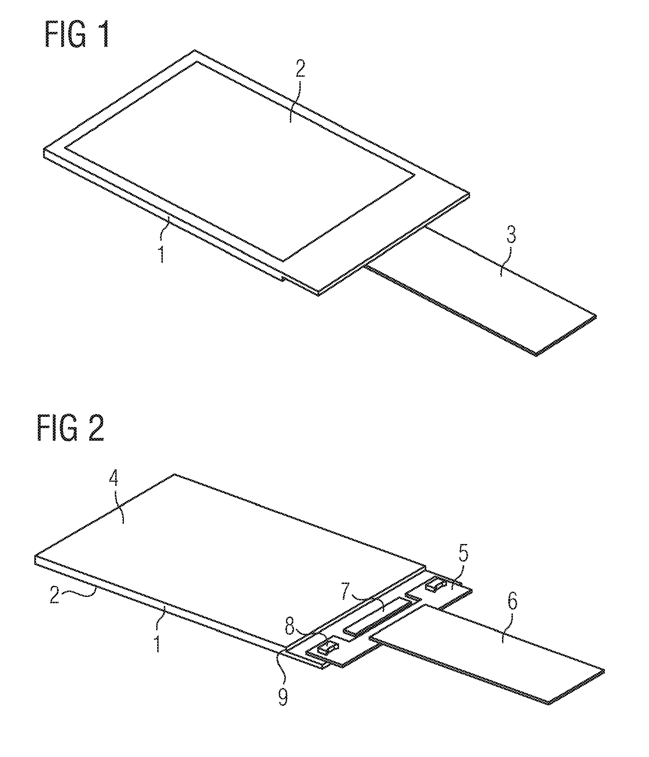

Figur 1 zeigt ein Display-Modul 1 mit einer Betrachterseite 2. Zum Anschluss des Display-Moduls 1 ist eine flexible Leiterbahnenverbindung 3 vorgesehen, die hier im Ausführungsbeispiel eine Heatseal-Folie ist.

Die Heatseal-Folie 3 ist zum Display-Modul 1 hin mit dem Display-Modul 1 kontaktiert.

Für eine Ansteuerung des Display-Moduls 1 durch eine entsprechende Steuerschaltung, die in der Figur 1 nicht näher gezeigt ist, wäre die der mit dem Display-Modul 1 verbundenen Seite gegenüberliegende Seite der flexiblen Leiterbahnenverbindung 3, diejenige Seite also, die in der Figur 1 frei endet, mit einer Leiterplatte zu kontaktieren, auf der die Steuerschaltung zum Steuern des Display-Moduls montiert ist.

Die flexible Leiterbahnenverbindung 3 zeigt nicht explizit die Leiterbahnen, über die jeweils einander entsprechende Kontaktierungsstellen auf der Seite der Leiterplatte und auf der Seite des Display-Moduls 1 miteinander elektrisch verbunden werden.

In der Figur 2 ist das Display-Modul 1 aus der Figur 1 in umgedrehter Ansicht gezeigt, das heißt, der Blick fällt auf die Unterseite 4 des Display-Moduls 1. Gegenüber der Figur 1 ist das Display-Modul 1 nicht mit einer Heatseal-Folie kontaktiert sondern mit einem Anschlusssystem gemäß der Erfindung. Dieses umfasst eine erste Leiterbahnenverbindung 5 und eine zweite Leiterbahnenverbindung 6.

Beide Leiterbahnenverbindungen 5 und 6 ersetzen zusammen die Leiterbahnenverbindung 3 in der Figur 1. Einzeln sind sie jedoch jeweils mit speziellen mechanischen Abmessungen gefertigt. Zusammen überbrücken sie die gleiche Strecke zwischen dem Display-Modul 1 und der bereits angesprochenen Leiterplatte wie die in der Figur 1 verwendete Leiterbahnenverbindung 3.

Im Detail ist die Leiterbahnenverbindung 5 eine teure und aufwändige Komponente, auf der elektrische Bauelemente platziert werden können und bei der der Leiterbahnenwiderstand der darauf platzierten Leiterbahnen niedrig ist. Hier im vorliegenden Ausführungsbeispiel ist die Leiterbahnenverbindung 5 durch eine FPC-Folie mit Kupferleiterbahnen realisiert.

Weiter ist im Detail die Leiterbahnenverbindung 6 eine Leiterbahnenverbindung, auf der keine elektrischen Bauelemente platziert werden können und die Leiterbahnen mit höheren Leiterbahnenwiderständen hat. Eine solche Leiterbahnenverbindung ist jedoch preiswert. Hier im vorliegenden Ausführungsbeispiel ist die Leiterbahnenverbindung 6 durch eine Heatseal-Folie mit Karbonleiterbahnen realisiert.

Die erste flexible Leiterbahnenfolie 5 ist zum Display-Modul 1 über einen elektronischen Kontrollbaustein 7 mit dem Display-Modul 1 kontaktiert. Die zweite flexible Leiterbahnenfolie 6 wird zur Leiterplatte hin, die in der Figur 2 nicht explizit gezeigt ist, mit der Leiterplatte kontaktiert. Schließlich sind die erste und zweite flexible Leiterbahnenfolie untereinander miteinander kontaktiert.

Die erste flexible Leiterbahnenfolie 5 ist bezüglich der mechanischen Abmessungen im Wesentlichen beschränkt auf das Display-Modul 1 ausgeführt. Die zweite flexible Leiterbahnenfolie 6 ist bezüglich der mechanischen Abmessungen in der Weise ausgeführt, dass durch die zweite flexible Leiterbahnenfolie 6 im Wesentlichen die gesamte Strecke zwischen dem Display-Modul 1 und der betreffenden zugeordneten Leiterplatte überbrückt ist.

An dieser Stelle ist angemerkt, dass im vorliegenden Ausführungsbeispiel gemäß der Figur 2 die Ankontaktierung der ersten flexiblen Leiterbahnenfolie 5 an das Display-Modul 1 über einen elektronischen Kontrollbaustein 7 erfolgt, der auf dem Display-Modul 1 angeordnet ist und der aus den über das Anschlusssystem gemäß der Erfindung übertragenen spannungsgesteuerten Signalen die entsprechenden Steuersignale für ein Anzeigebild auf der Betrachterseite des Display-Moduls generiert.

Wie aus der Figur 2 zu sehen ist, sind auf der ersten Leiterbahnenfolie 5 über die Leiterbahnen der flexiblen ersten und zweiten Leiterbahnenfolie 5 und 6 zum Beispiel direkt von einer von Seiten der zugehörigen Leiterplatte mit elektrischer Energie versorgte Licht erzeugende und Licht abgebende elektrische Bauteile 8 angeordnet. Sie sind insbesondere in der Weise auf der ersten flexiblen Leiterbahnenfolie 5 angeordnet, dass deren abgegebenes Licht in eine solche Stirnseite 9 des Display-Moduls 1 einstrahlt, dass das Display-Modul 1 durch das eingestrahlte Licht für einen Betrachter der Betrachterseite 2, auf der durch das Display-Modul 1 eine entsprechende Anzeige erzeugt ist, einen Beleuchtungseffekt hat.

Dabei können zumindest auf der zweiten flexiblen Leiterbahnenfolie 6 zur Reduzierung des Leiterbahnenwiderstandes insbesondere für die für die elektrische Energieversorgung der Licht erzeugenden und Licht abgebenden elektrischen Bauteile zuständigen Leiterbahnen mehrere solcher Leiterbahnen vorgesehen und diese mehreren Leiterbahnen durch Parallelschaltung zu Mehrfach-Leitungssträngen zusammengefasst sein.

In einer anderen Ausgestaltung der Erfindung ist es denkbar, dass diejenigen Teilstücke der ersten flexiblen Leiterbahnenfolie 5, die Leiterbahnen betreffen, über die die Licht erzeugenden elektrischen Bauteile 8 mit elektrischer Energie versorgt sind, bezüglich der mechanischen Abmessungen wesentlich über das Display-Modul 1 hinausragend verlängert und entsprechende Teilstücke der zweiten flexiblen Leiterbahnenfolie 6 bezüglich der mechanischen Abmessungen entsprechend verkürzt ausgebildet sind.

## Patentansprüche

1. Anschlusssystem zum Anschluss eines Display-Moduls an eine Leiterplatte, bestehend aus einer flexiblen Leiterbahnenverbindung, welche eine erste flexible Leiterbahnenfolie umfasst, welche zur Verbindung mit einem auf dem Display-Modul angeordneten Kontrollbaustein vorgesehen ist und die als sich im Wesentlichen über die Breite des Display-Moduls erstreckend ausgeführt ist, **dadurch gekennzeichnet , dass** eine zweite flexible Leiterbahnenfolie (6) vorgesehen ist, welche zur Verbindung der ersten flexiblen Leiterbahnenfolie (5) mit der Leiterplatte vorgesehen ist, dass die erste und die zweite Leiterbahnenfolie (5; 6) miteinander kontaktiert sind, dass auf der ersten flexiblen Leiterbahnenfolie (5) Licht erzeugende elektrische Bauteile (8) angeordnet sind, deren abgegebenes Licht in eine Stirnseite des Display-Moduls (1) eingestrahlt wird, so dass das Display-Modul (1) durch das eingestrahlte Licht für einen Betrachter einer mit Hilfe des Display-Moduls (1) erzeugten Anzeige mit einem Beleuchtungseffekt beaufschlagt ist, und dass die Leiterbahnen der ersten flexiblen Leiterbahnenfolie (5) gegenüber denen der zweiten flexiblen Leiterbahnenfolie (6) geringere Leiterbahnenwiderstände aufweisen.

2. Anschlusssystem nach Anspruch 1, **dadurch gekennzeichnet, dass** die erste flexible Leiterbahnenfolie (5) eine FPC-Folie und die zweite flexible Leiterbahnenfolie (6) eine Heatseal-Folie ist.

3. Anschlusssystem nach Anspruch 1 oder 2, **dadurch gekennzeichnet, dass** die Leiterbahnen für die Versor- gung der Licht erzeugenden und Licht abgebenden elektrischen Bauteile (8) mit elektrischer Energie wenigstens auf der zweiten flexiblen Leiterbahnenfolie (6) als parallel geschaltete Mehrfach-Leitungsstränge ausgebildet sind.

4. Anschlusssystem nach einem der Ansprüche 1 bis 3, **dadurch gekennzeichnet, dass** die erste flexible Leiterbahnenfolie (5) bezüglich der mechanischen Abmessungen im Wesentlichen beschränkt auf das Display-Modul (1) ausgeführt ist, und dass die zweite flexible Leiterbahnenfolie (6) bezüglich der mechanischen Abmessungen in der Weise ausgeführt ist, dass durch die zweite flexible Leiterbahnenfolie (6) im Wesentlichen die gesamte Strecke zwischen dem Display-Modul (1) und der Leiterplatte überbrückt ist.

5. Anschlusssystem nach einem der Ansprüche 1 bis 3, **dadurch gekennzeichnet, dass** Teilstücke der ersten flexiblen Leiterbahnenfolie (5), die Leiterbahnen betreffen, über die die Licht erzeugenden elektrischen Bauteile (8) mit elektrischer Energie versorgt sind, bezüglich der mechanischen Abmessungen wesentlich über das Display-Modul (1) hinausragend verlängert und entsprechende Teilstücke der zweiten flexiblen Leiterbahnenfolie (6) bezüglich der mechanischen Abmessungen entsprechend verkürzt ausgebildet sind.
